**Europäisches Patentamt**

**European Patent Office**

**Office européen des brevets**

(19)

(11) **EP 1 596 239 A2**

(12) **EUROPÄISCHE PATENTANMELDUNG**

(43) Veröffentlichungstag:
**16.11.2005  Patentblatt 2005/46**

(51) Int Cl.⁷: **G02B 21/00**

(21) Anmeldenummer: **05103661.4**

(22) Anmeldetag: **03.05.2005**

(84) Benannte Vertragsstaaten:
**AT BE BG CH CY CZ DE DK EE ES FI FR GB GR
HU IE IS IT LI LT LU MC NL PL PT RO SE SI SK TR**
Benannte Erstreckungsstaaten:
**AL BA HR LV MK YU**

(30) Priorität: **12.05.2004  DE 102004023739**

(71) Anmelder: **Leica Microsystems Semiconductor
GmbH
35578 Wetzlar (DE)**

(72) Erfinder:
• **Rinn, Klaus, Prof. Dr.
35452 Heuchelheim (DE)**
• **Danner, Lambert
35584 Wetzlar (DE)**

(74) Vertreter: **Reichert, Werner Franz
Leica Microsystems AG,
Corporate Patents + Trademarks Department,
Ernst-Leitz-Strasse 17-37
35578 Wetzlar (DE)**

(54) **Messgerät und Verfahren zum Betreiben eines Messgeräts zur optischen Inspektion eines Objekts**

(57)    Die vorliegende Erfindung betrifft ein Messgerät und ein Verfahren zum Betreiben eines Messgeräts zur optischen Inspektion eines Objekts, wie beispielsweise ein Halbleitersubstrat, eine Beleuchtungsmaske oder einen optischen Datenträger. Das Messgerät (1) umfasst eine Lichtquelle (6, 13), einen Beleuchtungsstrahlengang (4, 5), einen Detektionsstrahlengang (11), eine im Beleuchtungsstrahlengang (4) angeordnete Beleuchtungsoptik (8) und/oder eine im Detektionsstrahlengang (11) angeordnete Abbildungsoptik (9), einen Detektor (10) und eine Positionsauswerteeinrichtung. Der Beleuchtungsstrahlengang (4, 5) erstreckt sich von der Lichtquelle (6, 13) zum Objekt (2) und der Detektionsstrahlengang (11) erstreckt sich vom Objekt (2) zum Detektor (10). Zumindest ein Teil des Objekts (2) ist mit Licht der Lichtquelle (6, 13) beleuchtbar und mit der Abbildungsoptik (9) auf den Detektor (10) abbildbar. Mit der Positionsauswerteeinrichtung ist der Anstand zwischen zwei Punkten des Objekts (2) bestimmbar. Zum Verringern der Messfehler bei Präzisionsmessungen ausgedehnter Strukturen (3), insbesondere von Linienstrukturen, ist das erfindungsgemäße Messgerät (1) dadurch gekennzeichnet, dass in einer Pupillenebene der Abbildungsoptik (9) oder der Beleuchtungsoptik (8) oder in einer hierzu im Beleuchtungs- oder Abbildungsstrahlengang (4, 5, 11) konjugierten Ebene ein Mittel (14, 15) vorgesehen ist, mit welchem der Intensität des Lichts der Lichtquelle (6, 13) einen Verlauf einer stetig monotonen Funktion aufprägbar ist.

EP 1 596 239 A2

**Beschreibung**

Die vorliegende Erfindung betrifft ein Messgerät und ein Verfahren zum Betreiben eines Messgeräts zur optischen Inspektion eines Objekts, wie beispielsweise ein Halbleitersubstrat, eine Beleuchtungsmaske oder einen optischen Datenträger. Das Messgerät umfasst eine Lichtquelle, einen Beleuchtungsstrahlengang, einen Detektionsstrahlengang, eine im Beleuchtungsstrahlengang angeordnete Beleuchtungsoptik und/oder eine im Detektionsstrahlengang angeordnete Abbildungsoptik, einen Detektor und eine Positionsauswerteeinrichtung. Der Beleuchtungsstrahlengang erstreckt sich von der Lichtquelle zum Objekt und der Detektionsstrahlengang erstreckt sich vom Objekt zum Detektor. Zumindest ein Teil des Objekts ist mit Licht der Lichtquelle beleuchtbar und mit der Abbildungsoptik auf den Detektor abbildbar. Mit der Positionsauswerteeinrichtung ist der Anstand zwischen zwei Punkten des Objekts bestimmbar.

Messgeräte der gattungsbildenden Art sind seit geraumer Zeit bekannt, lediglich beispielhaft wird auf die DE 198 19 492 A1 hingewiesen, aus der ein gattungsbildendes Messgerät bekannt ist. Dieses Messgerät dient zur hochgenauen Messung der Koordinaten von Strukturen auf Substraten, z.B. Masken, Wafern, Flachbildschirmen, Aufdampfstrukturen, Halbleitersubstraten, Beleuchtungsmasken oder optischen Datenträgern, insbesondere aber für transparente Substrate. Die Koordinaten werden relativ zu einem Bezugspunkt auf wenige Nanometer genau bestimmt. Bei dieser optischen Inspektionstechnik werden komplexe Strukturen von Objekten auf flachen Substraten bildfeldweise inspiziert. Zum bildfeldweisen Inspizieren der Objekte wird das Objekt üblicherweise mittels - beispielsweise in Form von Positionier- oder Messtischen ausgebildete - Positioniermittel relativ zur Abbildungsoptik bewegt, so dass auch unterschiedliche Bereiche des Objekts detektiert werden können.

Eine Positionsauswerteeinrichtung weist üblicherweise Mittel auf, mit denen eine Objektstruktur detektiert bzw. klassifiziert werden kann, mit denen eine weitere Objektstruktur an einer anderen Stelle des Objekts - gegebenenfalls mit dem Positioniermittel an einer anderen Relativposition zur Abbildungsoptik positioniert - ebenfalls detektiert bzw. klassifiziert werden kann und mit welchen die Relativposition der Objektstrukturen zueinander ermittelt werden kann. Bei diesen Mitteln kann es sich beispielsweise um eine CCD-Kamera, einen Computer und ein entsprechendes Analyse- und Auswertungsprogramm handeln, wobei mit der CCD-Kamera das Bildfeld des Objekts an einer Position detektiert und in digitalisierter Form einem Computer zugeführt werden kann. Ein auf dem Computer laufendes Auswertungsprogramm führt die Detektion beziehungsweise Klassifikation der Objektstrukturen anhand der digitalisierten Bilddaten und gegebenenfalls vorgegebene Objektinformationen sowie deren Abstandsbestimmung durch.

Da die zu detektierenden Objekte zunehmend kleinere Strukturen aufweisen, ist es erforderlich, die optische Auflösung des Messgeräts zu erhöhen. Dies kann durch die Erhöhung der numerischen Apertur der Abbildungsoptik und/oder durch eine Verringerung der Wellenlänge des zur Detektion verwendeten Lichts erzielt werden. Hierdurch kann die nominelle Auflösung einer Abbildungsoptik vor allem für Punktobjekte erhöht werden, so dass der Durchmesser des zentralen Beugungsmaximums bzw. des klassischen Beugungsscheibchens bei der Objektbeleuchtung verringert werden kann. Beide Lösungsansätze stoßen jedoch auf prinzipielle Grenzen, welche eine weitere Auflösungserhöhung sehr aufwändig machen. Aber insbesondere Präzisionsmessungen von Linienstrukturen in einem mehrfachen Auflösungsabstand sind problematisch, da die Nebenmaxima des klassischen Beugungsscheibchens die Messung von Punkten von Strukturen, welche sich von einem Ausgangspunkt nicht erst im Abstand des ersten Beugungsminimums befinden, ebenfalls beeinträchtigen. Die Nebenmaxima des klassischen Beugungsscheibchens weisen einen Abstand zueinander auf, welcher das Auflösungsvermögen der Abbildungsoptik bei weitem übertrifft. Je kleiner der geforderte Messfehler ist, umso größer muss der Abstand der gemessenen Strukturen zu benachbarten Strukturen sein. Man hat somit eine Verringerung der effektiven Auflösung der Strukturen durch das Messgerät.

Der vorliegenden Erfindung liegt daher die Aufgabe zugrunde, ein Messgerät und ein Verfahren zum Betreiben eines Messgeräts zur optischen Inspektion eines Objekts anzugeben und weiterzubilden, mit welchem Präzisionsmessungen ausgedehnter Strukturen, insbesondere von Linienstrukturen, mit einem verringerten Messfehler möglich sind.

Das erfindungsgemäße Messgerät der gattungsbildenden Art löst die voranstehende Aufgabe durch die Merkmale des Patentanspruchs 1. Danach ist ein solches Messgerät dadurch gekennzeichnet, dass in einer Pupillenebene bzw. in einer Aperturebene der Abbildungsoptik und/oder in einer Pupillenebene bzw. in einer Aperturebene der Beleuchtungsoptik oder in einer hierzu im Beleuchtungs- oder Abbildungsstrahlengang konjugierten bzw. korrespondierenden Ebene ein Mittel vorgesehen ist, mit welchem der Intensität des Lichts der Lichtquelle einen Verlauf einer - zumindest abschnittsweise - stetig monotonen Funktion in guter Näherung aufprägbar ist.

Erfindungsgemäß ist zunächst erkannt worden, dass die nominelle Auflösung eines Messgeräts der gattungsbildenden Art bei hochgenauen Positions- und Linienbreitenmessungen in die Irre führt, gerade weil die Einflüsse der Nebenmaxima des klassischen Beugungsscheibchens die Abbildungseigenschaften negativ beeinflussen und hierdurch der Messfehler tatsächlich höher ist, als er eigentlich sein sollte. Je genauer eine Messung sein soll, um so empfindlicher tragen auch kleine Störungen durch benachbarte Strukturen bei, insbesondere dann, wenn sie durch die Nebenmaxima des klassischen Beugungsscheibchens hervorgerufen werden.

In erfindungsgemäßer Weise wird der Intensität des Lichts ein Verlauf aufgeprägt, welcher - zumindest abschnittsweise - einer stetig monotonen, vorzugsweise einer streng monotonen, Funktion entspricht. Hiermit ist insbesondere gemeint, dass die Funktion in einem Abschnitt im Wesentlichen einen konstanten Wert aufweisen kann, allerdings bezüglich der Funktionswerte in Abhängigkeit der Ortskoordinate insbesondere keine Sprünge oder Treppenfunktionsabschnitte aufweist. Eine solche Vorgehensweise wird auch Apodisierung genannt und ist seit langem aus dem Stand der Technik bei der Anwendung in der Lichtmikroskopie oder der Spektroskopie bekannt. Lediglich beispielhaft wird hierzu auf die DE 34 04 810 A1 verwiesen. Bei Messgeräten der eingangs genannten Art und insbesondere bei der Lithographie wurde bislang mit einer so genannten "off-Axis-Beleuchtung" gearbeitet, welche üblicherweise mit einer in einer zur Pupillenebene der Beleuchtungsoptik konjugierten Ebene angeordnete Blende (Ringblende) realisiert wird, die mit Ausnahme eines ringförmigen Bereichs mit einer Transmissionscharakteristik von ca. 0 % eine Transmissionscharakteristik von nahezu 100 % aufweist. Eine solche binäre Beleuchtungscharakteristik entspricht einer unstetigen Funktion, welche ein Beugungsscheibchen kleinen Durchmessers - und somit einer hohen Auflösung - jedoch nicht vernachlässigbare Nebenmaxima erzeugt.

Durch eine geschickte Auswahl eines entsprechenden Lichtintensitätsverlaufs in einer Pupillenebene der Beleuchtungsoptik, welche von der Eigenschaft der Beleuchtungsoptik abhängt, kann das Beleuchtungsmuster in der Objektebene beziehungsweise in der Fokalebene der Abbildungsoptik verändert werden. Insoweit kann das Mittel derart ausgebildet werden, dass die Nebenmaxima vollständig beseitigt werden, wobei dann jedoch der Durchmesser des klassischen Beugungsscheibchens bzw. des Beugungsmaximums vergrößert wird. Hierdurch wird das Auflösungsvermögen des Messgeräts insgesamt geringfügig verringert, es wird jedoch die erzielbare Messgenauigkeit ganz erheblich erhöht. Eine solche Beleuchtungscharakteristik ist bei Messgeräten der eingangs genannten Art hingegen völlig neu. Mit anderen Worten wird das in der konventionellen Mikroskopie unter der Bezeichnung Apodisierung bekannte Beleuchtungsverfahren auf Messgeräte zur optischen Inspektion von Objekten aus der Halbleiterindustrie bzw. zur optischen Inspektion von künstlichen Objekten angewandt bzw. dafür verwendet. Hierdurch können im ganz besonders vorteilhafter Weise nanometergenaue Messungen mit einem verringerten Messfehler durchgeführt werden, wodurch insgesamt die quantitativen Messungen verbessert werden.

Somit kann das erfindungsgemäße Messgerät beispielsweise zur hochgenauen Messung der Koordinaten von Strukturen auf Substraten, z.B. Masken, Wafern, Flachbildschirmen, Aufdampfstrukturen, Halbleitersubstraten, Beleuchtungsmasken oder optischen Datenträgern, insbesondere aber für transparente Substrate, dienen, wobei die Koordinaten relativ zu einem Bezugspunkt auf wenige Nanometer genau bestimmt werden (optische Inspektionstechnik).

In konstruktiver Hinsicht könnte das Mittel beispielsweise in Form eines Transmissionsfilters ausgebildet sein, welches in einer Pupillenebene der Abbildungsoptik angeordnet ist.

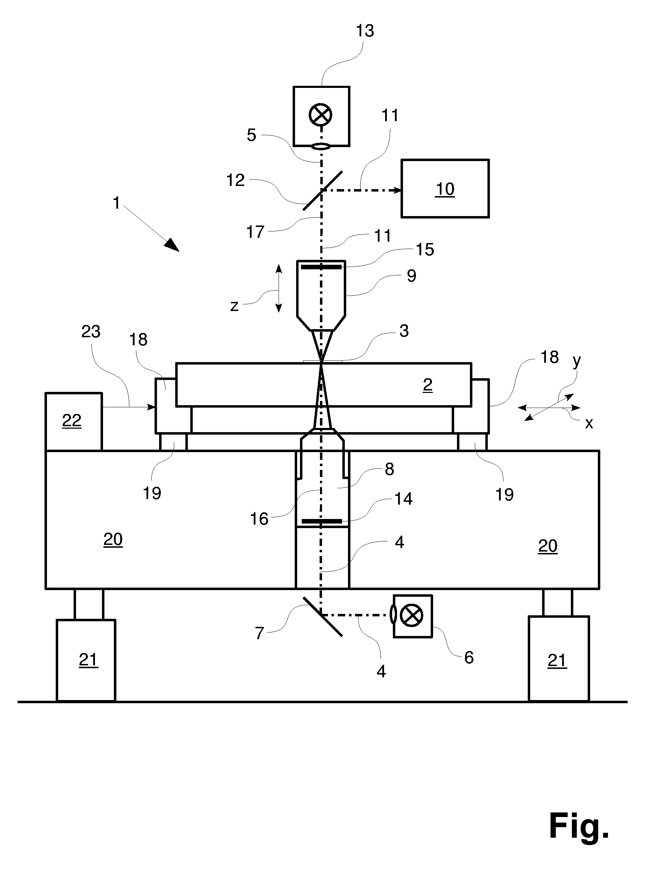

Eine Beleuchtung des Objekts könnte im Auflichtmodus oder im Durchlichtmodus erfolgen. Im Fall einer Durchlichtbeleuchtung für transparente Objekte erfolgt die Beleuchtung von einer Seite der Objektebene her. Beispielsweise könnte eine Köhler'sche Beleuchtung mit einer UV- Lichtquelle und einer Kondensoroptik realisiert sein. Dementsprechend umfasst der Beleuchtungsstrahlengang die in Form der Kondensoroptik ausgebildete Beleuchtungsoptik und erstreckt sich von der Lichtquelle bis zum Objekt. Die Detektion bzw. die Abbildung des das Objekt transmittierenden Lichts erfolgt in diesem Fall mit einem auf der gegenüberliegenden Seite der Objektebene angeordneten Detektor, wobei der Detektionsstrahlengang eine Abbildungsoptik - beispielsweise in Form eines Mikroskopobjektivs ausgeführt - aufweist und sich vom Objekt bis zum Detektor erstreckt.

Im Fall einer Auflichtbeleuchtung, welche auch bei nicht transparenten Objekten angewandt werden kann, erfolgt sowohl die Beleuchtung als auch die Detektion des Objekts von der gleichen Seite des Objekts aus. So beleuchtet das Licht einer Lichtquelle - gegebenenfalls über eine Zwischenoptik - das Objekt, wobei das Beleuchtungslicht durch die Abbildungsoptik auf das Objekt geleitet wird. In diesem Fall ist die Beleuchtungsoptik gleichzeitig die Abbildungsoptik im Beleuchtungs- bzw. Detektionsstrahlengang. Das am Objekt reflektierte Licht wird über die Abbildungsoptik auf einen Detektor abgebildet, wobei üblicherweise mit Hilfe eines Strahlteilers der Detektionsstrahlengang vom Beleuchtungsstrahlengang getrennt wird.

In einer bevorzugten Ausführungsform weist der Beleuchtungs- oder Abbildungsstrahlengang eine optische Achse auf. Mit dem Mittel ist die Lichtintensität des Beleuchtungs- oder Abbildungsstrahlengangs bezüglich der optischen Achse nach außen, also in radialer Richtung, verringerbar. Die Verringerung der Lichtintensität kann nach einer beliebigen stetig monotonen Funktion erfolgen, wobei die Funktion von den Eigenschaften der Beleuchtungs- bzw. Abbildungsoptik sowie von der Wellenlänge des verwendeten Lichts abhängen kann. So könnte die Funktion beispielsweise einen Bereich aufweisen, bei welchem der Intensitätsverlauf des Lichts linear oder quadratisch verringert wird. Ganz besonders bevorzugt ist mit dem Mittel die Lichtintensität gemäß der Funktion

$$I(r)=I_0*\cos^2(f*r/a)$$

einstellbar ist, wobei $I_0$ ein von der Lichtquelle abhängiger, vorgebbarer Intensitätswert, f ein vorgebbarer Faktor, r den Abstand zur optischen Achse des Beleuchtungs- oder Abbildungsstrahlengangs in radialer Richtung und a der Aperturdurchmesser der Abbildungsoptik ist. Der Faktor f weist vorzugsweise den Wert $\pi/2$ auf. Bei einem solchen Funktionsverlauf sind die Nebenmaxima nahezu vollständig beseitigt und dementsprechend die Messfehler minimiert. Mit dem * in der Funktionsgleichung ist eine mathematische Multiplikation gekennzeichnet. Ein solcher Funktionsverlauf des Mittels könnte beispielsweise mit einem Transmissionsfilter realisiert werden, das eine entsprechend nicht transmittierende oder reflektierende Beschichtung aufweist.

Grundsätzlich könnte das Messgerät ständig mit einem Mittel in erfindungsgemäßer Weise ausgebildet sein und dementsprechend Objekte bei sämtlichen Messvorgängen stets mit dem stetig monotonen Lichtintensitätsverlauf in der Pupillenebene beleuchten. Es kann jedoch vorteilhaft sein, ein Objekt einerseits in herkömmlicher Weise und andererseits in erfindungsgemäßer Weise zu beleuchten und jeweils zu detektieren. Die so detektierten Objektbilder können einer statistischen Auswertung - beispielsweise einer Mittelung - zugeführt werden, so dass ganz besonders vorteilhaft die resultierende Messgenauigkeit noch weiter erhöht werden kann. Hierzu könnte das Mittel reversibel in den Beleuchtungs- oder Abbildungsstrahlengang einbringbar sein, beispielsweise mit Hilfe eines Filterschiebers, welcher ein in Form eines Filters ausgebildetes Mittel in den Beleuchtungs- oder Abbildungsstrahlengang hinein und aus diesem wieder heraus bewegen kann.

Weiterhin könnte das Mittel zeitlich veränderbar ausgeführt sein, so dass die Lichtintensität des zur Objektbeleuchtung dienenden Lichts mit dem Mittel zeitlich veränderbar ist. In diesem Fall könnte das Mittel eine zumindest teilweise transparente LCD-Einheit (Liquid Crystal Device) aufweisen, mit welcher von einer Steuereinheit angesteuert eine veränderbare Transmissionscharakteristik der LCD-Einheit an unterschiedlichen Stellen realisierbar ist.

Üblicherweise ist das zu detektierende Objekt größer als der von der Abbildungsoptik abbildbare Objektbereich. In einer bevorzugten Ausführungsform ist daher mindestens ein Positioniermittel vorgesehen, mit welchem die Relativposition zwischen dem Objekt und der Abbildungsoptik veränderbar ist. Somit können unterschiedliche Bereiche des Objekts derart relativ zur Abbildungsoptik positioniert werden, dass sie jeweils auf den Detektor abgebildet werden. Es muss jedoch der zurückgelegte Weg des Objekts bei dem Positioniervorgang so genau wie möglich detektiert werden, da dieser unmittelbar in das Messergebnis eingeht. Daher ist vorzugsweise eine mit dem Positioniermittel bewirkte Veränderung der Relativposition zwischen dem Objekt und der Abbildungsoptik interferometrisch detektierbar. Im Konkreten könnte das Positioniermittel einen Objektverschiebetisch aufweisen, mit welchem das Objekt in mindestens zwei unterschiedlichen Richtungen positionierbar ist. Der Objektverschiebetisch könnte Baugruppen mindestens eines Interferometers aufweisen, mit welchem bzw. welchen die Wegdifferenz zwischen zwei Objektpositionen interferometrisch bestimmbar sind. Insoweit könnte diesbezüglich auf Systemkomponenten zurückgegriffen werden, welche aus dem Stand der Technik bekannt sind und wie sie beispielsweise in der DE 198 19 492 A1 vorgesehen sind.

In einer ganz besonders bevorzugten Ausführungsform weist der Detektor eine hochauflösende CCD-Kamera auf. Die Abbildungsoptik könnte eine hochauflösende, apo-chromatisch korrigierte Mikroskopoptik aufweisen, welche für Beleuchtungslicht im UV, vorzugsweise im nahen UV, ausgelegt ist. Somit weist das so ausgestattete Messgerät sowohl hinsichtlich der optischen Abbildung als auch hinsichtlich der Detektion des Objektbilds ein hohes Auflösungsvermögen und eine nahezu fehlerfreie Objektabbildung auf.

In verfahrensmäßiger Hinsicht wird die eingangs genannte Aufgabe durch die Merkmale des Patentanspruchs 15 gelöst. Das erfindungsgemäße Verfahren dient vorzugsweise zum Betreiben eines Messgeräts nach einem der Patentansprüche 1 bis 14. Hierbei wird zumindest ein Teil des Objekts mit Licht einer Lichtquelle beleuchtet und mit einer Abbildungsoptik auf einen Detektor abgebildet. Mit einer Positionsauswerteeinrichtung wird der Abstand zwischen zwei Punkten des Objekts bestimmt.

Erfindungsgemäß wird in einer Pupillenebene der Abbildungsoptik oder der Beleuchtungsoptik oder in einer hierzu im Beleuchtungs- oder Abbildungsstrahlengang konjugierten Ebene ein Mittel vorgesehen, mit welchem die Intensität des Lichts der Lichtquelle einen Verlauf einer - zumindest abschnittsweise - stetig monotonen Funktion beeinflusst wird.

Wie bereits angedeutet, könnte das Objekt zumindest bei einer Detektion mit einer Intensitätsverteilung gemäß Patentanspruch 15 detektiert werden. Bei einer weiteren Detektion könnte das Objekt mit einer herkömmlichen - beispielsweise einer "off-Axis" - Intensitätsverteilung beleuchtet werden. Die so detektierten Bilder könnten einer statistischen Auswertung zugeführt werden, wodurch aufgrund der mehrmaligen Detektion und der nachgeschalteten statistischen Auswertung der Bilddaten des Objekts der Messfehler weiter verringert und die Genauigkeit der quantitativen Messung daher erhöht werden kann. Zur Vermeidung von Wiederholungen wird auf den vorangegangenen Teil der Beschreibung verwiesen.

Es gibt nun verschiedene Möglichkeiten, die Lehre der vorliegenden Erfindung in vorteilhafter Weise auszugestalten und weiterzubilden. Dazu ist einerseits auf die dem Patentanspruch 1 nachgeordneten Patentansprüche und andererseits auf die nachfolgende Erläuterung eines bevorzugten Ausführungsbeispiels der Erfindung anhand der Zeichnung zu verweisen. In Verbindung mit der Erläuterung des bevorzugten Ausführungsbeispiels der Erfindung anhand der Zeichnung werden auch im Allgemeinen bevorzugte Ausgestaltungen und Weiterbildungen der Lehre erläutert. In der Zeichnung zeigt die einzige

Fig.     eine schematische Darstellung eines Ausführungsbeispiels eines erfindungsgemäßen Messgeräts.

Die einzige Fig. zeigt ein erfindungsgemäßes Messgerät 1, mit welchem Objekte 2 optisch inspiziert werden können. Bei dem in der Fig. gezeigten Objekt 2 handelt es sich um eine Maske, welche beispielsweise aus Quarzglas besteht. Auf der Maske sind Strukturen 3 aufgebracht, welche mit dem Messgerät 1 inspiziert werden. Das Messgerät 1 umfasst zwei Beleuchtungsstrahlengänge 4 und 5, wobei der Beleuchtungsstrahlengang 4 für den Durchlichtmodus und der Beleuchtungsstrahlengang 5 für den Auflichtmodus des Messgeräts 1 vorgesehen ist. Für den Durchlichtmodus ist eine Lichtquelle 6 vorgesehen, welche Licht im nahen UV emmitiert und welches von dem Spiegel 7 in Richtung der in Form eines Kondensors 8 ausgebildeten Beleuchtungsoptik reflektiert wird. Das Licht des Beleuchtungsstrahlengangs 4 tritt durch das Objekt 2 und wird zumindest größtenteils von der Abbildungsoptik 9 aufgesammelt und auf den Detektor 10 abgebildet. Der Detektionsstrahlengang 11 erstreckt sich somit vom Objekt 2 zum Detektor 10, wobei das vom Objekt 2 kommende Licht nahezu vollständig von dem Strahlteiler 12 in Richtung des Detektors 10 reflektiert wird. Die Abbildungsoptik 9 kann mit einer in der Figur nicht gezeigten Fokussierungseinrichtung entlang der mit dem Doppelpfeil gekennzeichneten z-Richtung bewegt werden, wodurch das Objekt 2 beziehungsweise die Strukturen 3 fokussiert werden können. In gleicher Weise kann der Kondensor 8 entlang der z-Richtung bewegt werden.

Das Messgerät 1 weist auch einen Auflichtmodus auf. In diesem Modus erfolgt die Beleuchtung des Objekts 2 mit Licht der Lichtquelle 13, welches zum größten Teil den Strahlteiler 12 passiert und über die Abbildungsoptik 9 das Objekt 2 beleuchtet. Das am Objekt 2 beziehungsweise an den Strukturen 3 reflektierte Beleuchtungslicht durchläuft in diesem Modus in umgekehrter Richtung die Abbildungsoptik 9 und wird ebenfalls am Strahlteiler 12 in Richtung des Detektors 10 reflektiert. Dementsprechend erstreckt sich der Beleuchtungsstrahlengang 5 von der Lichtquelle 13 zum Objekt 2. Der Beleuchtungsstrahlengang 4 erstreckt sich von der Lichtquelle 6 zum Objekt 2.

Bei der Abbildungsoptik 9 handelt es sich um eine hochauflösende, apo-chromatisch korrigierte Mikroskopoptik, welche für Licht im nahen UV-Bereich ausgelegt ist. Der Detektor 10 ist in Form einer hochauflösenden CCD-Kamera ausgebildet und wird von einem in der Fig. nicht gezeigten Computer-Auswerte- und Analysesystem angesteuert und ausgelesen.

Erfindungsgemäß weist das Messgerät 1 ein in Form eines Filters 14 und 15 ausgebildetes Mittel auf, welches einerseits in dem Beleuchtungsstrahlengang 4 und andererseits in dem Beleuchtungsstrahlengang 5 angeordnet ist. Der Filter 14 ist in der Pupillenebene der in Form des Kondensors 8 ausgebildeten Beleuchtungsoptik im Beleuchtungsstrahlengang 4 angeordnet. Der Filter 15 ist in der Pupillenebene der Abbildungsoptik 9 des Beleuchtungsstrahlengangs 5 angeordnet. Insoweit wirkt der Filter 15, da er in diesem Ausführungsbeispiel beispielsweise nicht zwischen der Lichtquelle 13 und dem Strahlteiler 12 angeordnet ist, auch im Detektionsstrahlengang 11.

Bei den Filtern 14 und 15 handelt es sich um Transmissionsfilter, die eine Transmissionscharakteristik gemäß der Funktion

$$I(r) = I_0 * \cos^2 (f * r / a)$$

aufweisen, wobei $I_0$ ein von der Lichtquelle 6, 13 abhängiger, vorgebbarer Intensitätswert, f den Wert $\pi/2$ aufweist, r den Abstand zur optischen Achse 16, 17 des Beleuchtungsstrahlengangs 4, 5 in radialer Richtung und a der Aperturdurchmesser der Abbildungsoptik 9 bzw. der Beleuchtungsoptik 8 ist. Dementsprechend ist die im äußeren Bereich der Transmissionsfilter vorliegende Lichtintensität des transmittierten Lichts geringer als die bei den optischen Achsen 16 und 17 der Beleuchtungsstrahlengänge 4 und 5 vorliegende Lichtintensität. Obwohl die Filter 14 und 15 in der Fig. dem Kondensor 8 bzw. der Abbildungsoptik 9 zugeordnet eingezeichnet sind könnten diese auch reversibel in den jeweiligen Strahlengang einbringbar sein, beispielsweise mit Hilfe jeweils eines Filterschiebers. Sie könnten auch jeweils in einer Ebene in den Beleuchtungsstrahlengängen 4, 5 angeordnet sein, welche zu einer Pupillenebene des Kondensors 8 oder der Abbildungsoptik 9 konjugiert ist.

Das Objekt 2 ist in einem in Form eines Messtischs ausgebildeten Positioniermittel 18 gelagert und entlang den mit den zwei Doppelpfeilen gekennzeichneten unterschiedlichen x- und y-Richtungen bewegbar gelagert. Das Positioniermittel 18 weist einen Rahmen auf, in welchen das Objekt 2 eingelegt ist. Lediglich schematisch ist das Laserinterferometersystem 22 angedeutet, mit welchem über den Lichtstrahl 23 die Position des Positioniermittels 18 interferometrisch vermessen werden kann. Der Rahmen des Positioniermittels 18 ist hierbei auf einem Luftkissen 19 gelagert und kann quasi reibungsfrei auf dem Granitblock 20 bewegt werden. Der Granitblock 20 selbst steht schwingungsgedämpft gelagert auf den Füßen 21.

Abschließend sei ganz besonders darauf hingewiesen, dass das voranstehend erörterte Ausführungsbeispiel lediglich zur Beschreibung der beanspruchten Lehre dient, diese jedoch nicht auf das Ausführungsbeispiel einschränkt.

**Bezugszeichenliste**

| | |
|---|---|
| 1 | Messgerät |
| 2 | Objekt |
| 3 | Strukturen von (2) |
| 4 | Beleuchtungsstrahlengang |
| 5 | Beleuchtungsstrahlengang |
| 6 | Lichtquelle von (4) |
| 7 | Spiegel |
| 8 | Kondensor |
| 9 | Abbildungsoptik |
| 10 | Detektor |
| 11 | Detektionsstrahlengang |
| 12 | Strahlteiler |
| 13 | Lichtquelle von (5) |
| 14 | Filter zum modulieren der Lichtintensität in (4) |
| 15 | Filter zum modulieren der Lichtintensität in (5) |
| 16 | Optischen Achse von (4) |
| 17 | Optischen Achse von (5) |
| 18 | Positioniermittel |
| 19 | Luftkissen für (18) |
| 20 | Granitblock |
| 21 | Füße für (20) |
| 22 | Laserinterferometersystem |
| 23 | Lichtstrahl von (22) |

**Patentansprüche**

1. Messgerät zur optischen Inspektion eines Objekts, wie beispielsweise ein Halbleitersubstrat, eine Beleuchtungsmaske oder einen optischen Datenträger, mit einer Lichtquelle (6, 13), einem Beleuchtungsstrahlengang (4, 5), einem Detektionsstrahlengang (11), einer im Beleuchtungsstrahlengang (4) angeordneten Beleuchtungsoptik (8) und/oder einer im Detektionsstrahlengang (11) angeordneten Abbildungsoptik (9), einem Detektor (10) und einer Positionsauswerteeinrichtung, wobei der Beleuchtungsstrahlengang (4, 5) sich von der Lichtquelle (6, 13) zum Objekt (2) und der Detektionsstrahlengang (11) sich vom Objekt (2) zum Detektor (10) erstreckt, wobei zumindest ein Teil des Objekts (2) mit Licht der Lichtquelle (6, 13) - beispielsweise im Auflichtmodus oder im Durchlichtmodus - beleuchtbar und mit der Abbildungsoptik (9) auf den Detektor (10) abbildbar ist, wobei mit der Positionsauswerteeinrichtung der Abstand zwischen zwei Punkten des Objekts (2) bestimmbar ist, **dadurch gekennzeichnet, dass** in einer Pupillenebene der Abbildungsoptik (9) oder der Beleuchtungsoptik (8) oder in einer hierzu im Beleuchtungs- oder Abbildungsstrahlengang (4, 5, 11) konjugierten Ebene ein Mittel (14, 15) vorgesehen ist, mit welchem der Intensität des Lichts der Lichtquelle (6, 13) einen Verlauf einer stetig monotonen Funktion aufprägbar ist.

2. Messgerät nach Anspruch 1, **dadurch gekennzeichnet, dass** der Beleuchtungs- oder Abbildungsstrahlengang (4, 5, 11) eine optischen Achse (16, 17) aufweist und dass mit dem Mittel (14, 15) die Lichtintensität des Beleuchtungs- oder Abbildungsstrahlengangs (4, 5, 11) bezüglich der optischen Achse (16, 17) nach außen verringerbar ist und/oder dass das Mittel (14, 15) vorzugsweise einen Transmissionsfilter aufweist.

3. Messgerät nach einem der Ansprüche 1 oder 2, **dadurch gekennzeichnet, dass** mit dem Mittel (14, 15) die Lichtintensität gemäß der Funktion

$$I(r) = I_0 * \cos^2 (f * r / a)$$

einstellbar ist, wobei $I_0$ ein von der Lichtquelle (6, 13) abhängiger, vorgebbarer Intensitätswert, f ein vorgebbarer Faktor - welcher vorzugsweise den Wert $\pi/2$ aufweist -, r den Abstand zur optischen Achse (16, 17) des Beleuchtungs- oder Abbildungsstrahlengangs (4, 5, 11) in radialer Richtung und a der Aperturdurchmesser der Abbildungsoptik (9) bzw. der Beleuchtungsoptik (8) ist.

4. Messgerät nach einem der Ansprüche 1 bis 3, **dadurch gekennzeichnet, dass** das Mittel (14, 15) reversibel in den Beleuchtungs- oder Abbildungsstrahlengang (4, 5, 11) einbringbar ist.

5. Messgerät nach einem der Ansprüche 1 bis 4, **dadurch gekennzeichnet, dass** die Lichtintensität mit dem Mittel (14, 15) zeitlich veränderbar ist und dass das Mittel (14, 15) vorzugsweise eine zumindest teilweise transparente LCD-Einheit (Liquid Crystal Device) aufweist, mit welcher von einer Steuereinheit angesteuert eine veränderbare Transmissionscharakteristik realisierbar ist.

6. Messgerät nach einem der Ansprüche 1 bis 5, **dadurch gekennzeichnet, dass** mindestens ein Positioniermittel (18) vorgesehen ist, mit welchem die Relativposition zwischen dem Objekt (2) und der Abbildungsoptik (9) veränderbar ist und dass vorzugsweise eine mit dem Positioniermittel (8) bewirkte Veränderung der Relativposition zwischen dem Objekt (2) und der Abbildungsoptik (9) interferometrisch detektierbar ist.

7. Messgerät nach einem der Ansprüche 1 bis 6, **dadurch gekennzeichnet, dass** das Positioniermittel (18) einen Objektverschiebetisch aufweist, mit welchem das Objekt (2) in mindestens zwei unterschiedlichen Richtungen (x, y) positionierbar ist und dass vorzugsweise der Objektverschiebetisch Baugruppen mindestens eines Interferometers (22) aufweist, mit welchem bzw. welchen die Wegdifferenz zwischen zwei Objektpositionen interferometrisch bestimmbar sind.

8. Messgerät nach einem der Ansprüche 1 bis 7, **dadurch gekennzeichnet, dass** der Detektor (10) eine hochauflösende CCD-Kamera aufweist und/oder dass die Abbildungsoptik (9) eine hochauflösende, apo-chromatisch korrigierte Mikroskopoptik aufweist, welche für Beleuchtungslicht im UV, vorzugsweise im nahen UV, ausgelegt ist.

9. Verfahren zum Betreiben eines - vorzugsweise nach einem der Ansprüche 1 bis 8 ausgebildeten - Messgeräts zur optischen Inspektion eines Objekts, wie beispielsweise ein Halbleitersubstrat, eine Beleuchtungsmaske oder ein optischer Datenträger, wobei das Messgerät eine Lichtquelle, einen Beleuchtungsstrahlengang (4, 5), einen Detektionsstrahlengang (11), eine im Beleuchtungsstrahlengang (4) angeordneten Beleuchtungsoptik (8) und/oder eine im Detektionsstrahlengang (11) angeordnete Abbildungsoptik (9), einen Detektor (10) und eine Positionsauswerteeinrichtung aufweist, wobei der Beleuchtungsstrahlengang (4, 5) sich von der Lichtquelle (6, 13) zum Objekt (2) und der Detektionsstrahlengang (11) sich vom Objekt (2) zum Detektor (10) erstreckt, wobei zumindest ein Teil des Objekts (2) mit Licht der Lichtquelle (6, 13) beleuchtet wird und mit der Abbildungsoptik (9) auf den Detektor (10) abgebildet wird, wobei mit der Positionsauswerteeinrichtung der Abstand zwischen zwei Punkten des Objekts (2) bestimmt wird, **dadurch gekennzeichnet, dass** in einer Pupillenebene der Abbildungsoptik (9) oder der Beleuchtungsoptik (8) oder in einer hierzu im Beleuchtungs- oder Abbildungsstrahlengang (4, 5, 11) konjugierten Ebene ein Mittel (14, 15) vorgesehen ist, mit welchem der Intensität des Lichts der Lichtquelle (6, 13) einen Verlauf einer stetig monotonen Funktion aufgeprägt wird.

10. Verfahren nach Anspruch 9, **dadurch gekennzeichnet, dass** das Objekt (2) mindestens bei einer Detektion mit einer Intensitätsverteilung gemäß Anspruch 15 und bei einer weiteren Detektion mit einer herkömmlichen Intensitätsverteilung beleuchtet wird und dass die so detektierten Bilder einer statistischen Auswertung zugeführt werden.

**Fig.**